# EUROPÄISCHE PATENTSCHRIFT

(11) **EP 0 708 926 B1**
(45) Veröffentlichungstag und Bekanntmachung des Hinweises auf die Patenterteilung: **19.02.1997**
(21) Anmeldenummer: 94922259.0
(22) Anmeldetag: 05.07.1994
(51) Int. Cl.: G01R 1/073

(54) **VOLLMATERIALADAPTER**
ADAPTER WITH SOLID BODY
ADAPTATEUR EN MATERIAU PLEIN

(30) Priorität: 12.07.1993 DE 4323276
(43) Veröffentlichungstag der Anmeldung: 01.05.1996
(73) Patentinhaber: MANIA GmbH & Co., D-61276 Weilrod (DE)
(72) Erfinder: DRILLER, Hubert, D-61389 Schmitten (DE); MANG, Paul, D-61389 Schmitten (DE)
(74) Vertreter: Ruschke, Hans Edvard
(86) Internationale Anmeldenummer: EP9402198
(87) Internationale Veröffentlichungsnummer: WO9502829

(56) Entgegenhaltungen:
- EP-A- 0 233 992
- WO-A-90/02954
- DE-A- 3 702 184
- DE-A- 3 801 222

## Beschreibung

Die vorliegende Erfindung betrifft einen Adapter zur Anpassung des gleichmäßigen Kontaktrasters einer elektronischen Prüfvorrichtung für Leiterplatten an die ungleichmäßige Kontaktkonfiguration der Anschlußpunkte auf einer zu prüfenden Leiterplatte gemäß dem Oberbegriff des Patentanspruches 1.

Der "Universaladapter" gemäß der EP-B1-26 824 weist eine auf dem Grundraster der Prüfvorrichtung aufliegende Grundplatte auf, die entsprechend dem gleichmäßigen Kontaktraster der Prüfvorrichtung mit durchgehenden Kanälen oder Bohrungen versehen ist. In einiger Entfernung über dem Grundraster, d. h. auf der vom Grundraster der Prüfvorrichtung abgewandten Seite der Grundplatte wird eine Anordnung aus von zwei zueinander beabstandeten Adapterplatten mit Hilfe von festen Abstandshaltern angeordnet. Diese Adapterplatten sind identisch mit Bohrungen versehen, die entsprechend den variabel angeordneten Anschlußpunkten der zu prüfenden Leiterplatte verteilt sind. In diese Bohrungen in den Adapterplatten werden dann nadelförmige, in Längsrichtung federnde Prüfstifte eingesetzt, die zum Ausgleich von eventuellen Fluchtungsfehlern zwischen den genannten prüflingsspezifischen Bohrungen und den rastergebundenen Kanälen zumindest in ihrem unteren Abschnitt quer zur Längserstreckung der Prüfstifte federnd auslenkbar sind. Bei einem solchen, aus mehreren Platten aufgebauten Adapter muß der Leiterplattenhersteller zumindest die prüflingsspezifischen Adapterplatten für jede Testserie speziell anfertigen, um den Adapter überhaupt aufbauen zu können, d.h. eine Rationalisierung ist bei der Adapterfertigung insoweit nicht möglich.

Da bei komplexen Leiterplatten viele tausend Anschlußpunkte vorgesehen sein können und für jeden Anschlußpunkt ein federnder Prüfstift benötigt wird, steigen die Kosten für einen solchen Adapter mit der Zahl der Anschlußpunkte stark an, da in Längsrichtung federnde Prüfstifte einen nicht unerheblichen Fertigungsaufwand erfordern. Es kommt hinzu, daß solche Prüfstifte einen kaum zu unterschreitenden Mindestdurchmesser haben müssen, der die natürliche Grenze für die mögliche Prüfstiftdichte darstellt.

Um in Längsrichtung starre und somit einfach herzustellende und besonders dünne Prüfstifte verwenden zu können, wurde ein "aktives Grundraster" geschaffen, bei dem die Kontakte des Grundrasters der Leiterplattenprüfvorrichtung im wesentlichen in Richtung der Längsachse der Prüfstifte federnd gelagert sind. Dieses aktive Grundraster wird auf das starre, fest verdrahtete Grundraster der Leiterplattenrprüfvorrichtung aufgesetzt und dient dazu, bei der Verwendung von starren Prüfstiften für einen ausreichend hohen und möglichst gleichmäßigen Kontaktdruck bei allen von den starren Prüfstiften kontaktierten Prüfpunkten zu sorgen.

Die EP-A1-0 215 146 zeigt einen Adapter ("Adapter 85"), dessen obere prüflingsspezifisch gebohrte Adapterplatte an der zu prüfenden Leiterplatte anliegt und dessen starre konturlose Prüfstifte eine im Abstand darunter angeordnete zusätzliche elastische Matte durchsetzen, die ungebohrt ist und aufgrund der Elastizität des Materials die Prüfstifte beim Hantieren mit dem Adapter unabhängig von der eigentlichen Prüfvorrichtung am Herausfallen hindern. Dadurch kann bei einer späteren Prüfung von gleichen Leiterplatten der nicht unerhebliche Arbeitsaufwand zum Bestücken des Adapters mit Prüfstiften gespart und stattdessen der Adapter bis zur erneuten Verwendung wieder aufbewahrt werden. Dieser Adapter bringt zwar den Vorteil, daß sehr billig herzustellende starre und völlig konturlose Prüfstifte verwendet werden können, doch wird die Bestückung des Adapters dadurch komplizierter, daß die Prüfstifte nicht einfach in den Adapter "hineinfallen" können, sondern durch die elastische ungebohrte Matte mit einem gewissen Kraftaufwand hindurchgedrückt werden müssen. Weiterhin weist dieser Adapter eine innere Adapterplatte auf, deren Raster jedoch weder dem Raster der äußeren Adapterplatte noch dem der Grundplatte entspricht. Dies bedeutet also, daß neben der prüfungsspezifisch gebohrten Adapterplatte mindestens eine weitere Adapterplatte mit einem Bohrungsmuster hergestellt werden muß, das von demjenigen der erstgenannten Adapterplatte abweicht.

Es gibt weitere Adapterbauformen, bei denen eine ganze Reihe von gebohrten Adapterplatten zwischen der prüflingsspezifisch gebohrten Adapterplatte und der auf dem Kontaktpunktraster des Prüfgerätes aufliegenden Rasterlochplatte des Adapters angeordnet sind. Die Bohrungsmuster der dazwischenliegenden Adapterplatten schaffen einen allmählichen Übergang von der prüflingsspezifisch gebohrten Adapterplatte zu der Rasterlochplatte und sind daher jeweils unterschiedlich, erfordern also einen höheren Fertigungs- und Materialaufwand bei der Herstellung solcher Adapter; zudem ist das Bestücken solcher Adapter mit den erforderlichen Prüfstiften besonders schwierig.

Die voranstehend abgehandelten Adapter sind für die einseitige Prüfung von Leiterplatten konzipiert worden. Es kommen jedoch zunehmend Leiterplatten zum Einsatz, die beidseitig mit Anschlußpunkten versehen sind, d. h. die Leiterplatten müssen auch von beiden Seiten geprüft werden. Dabei kann man sich zwar mit zwei aufeinanderfolgenden einseitigen Prüfungen behelfen, doch wird man dabei jedenfalls keine Leitungsunterbrechungen bei sogenannten "Durchsteigern" feststellen können, die zudem im Hinblick auf Leitungsunterbrechungen besonders empfindlich sind. Daher sind Leiterplattenprüfvorrichtungen entwickelt worden, die in der Lage sind, eine gleichzeitige beidseitige Prüfung von doppelseitig bestückbaren Leiterplatten vorzunehmen. Dies führt dann auch zur Notwendigkeit von Adaptern für derartige Prüfvorrichtungen. Leider sind viele Adapter nur in Ausnahmefällen für die gleichzeitige beidseitige Prüfung verwendbar, denn wenn die Anschlußpunkte auf beiden Seiten der zu prüfenden Leiterplatte ungleichmäßig verteilt sind, kommt es bei den bisweilen vielen tausend Prüfstiften zu erheblichen Verformungen bzw. Verwerfungen des Prüflings, was zu zusätzlichen (neuen) Fehlern in den Leiterbahnen oder gar zum Bruch der Leiterplatte führen kann - letzteres insbesondere bei Keramikplatten. Bei einer einseitigen Prüfung von Leiterplatten kann eine ungleichmäßige Verteilung oder örtliche Konzentrierung von Prüfstiften nicht zu einem solchen nachteiligen Effekt führen, weil das Widerlager auf der anderen Seite des Prüflings eine stabile Platte der eigentlichen Prüfvorrichtung sein kann, wobei diese Platte alle ungleichmäßigen Krafteinleitungen in die Leiterplatte im wesentlichen ohne Verwerfungen aufnimmt und somit die zu prüfende Leiterplatte in einem weitgehend unverformten Zustand abstützt. Bei einer gleichzeitig zweiseitigen Prüfung von Leiterplatten ist dies jedoch nicht möglich, weil das Widerlager bei lokal begrenzt fehlenden Prüfstiften auf der anderen Seite des Prüflings somit entweder nicht vorhanden ist oder die prüflingsspezifisch gebohrte Adapterplatte des anderen Adapters ist, wobei diese Adapterplatte nicht beliebig starr gemacht werden kann, zumal sie häufig aus Acrylglas oder dergleichen hergestellt wird, um den manuellen Bestückungsvorgang des Adapters zu erleichtern.

Das Problem des eventuell örtlich fehlenden Widerlagers und der damit lokal zu hohen Krafteinleitung in die zu prüfende Leiterplatte bei gleichzeitig beidseitiger Prüfung derselben wird beim Gegenstand der EP 0 315 707 ("Adapter 87") dadurch behoben, daß zusätzliche Abstützmittel in den Adapter an den besonders beanspruchten Stellen eingeführt werden, z. B. in Form von separaten federnden Stützstiften.

Angesichts der im Zuge der Miniaturisierung von Leiterplatten oder Verdrahtungsträgern weiter zunehmenden Dichte der Anschlußflächen der zu prüfenden Leiterplatten wird es aber immer schwieriger, den notwendigen Platz für diese Stützstifte zwischen den eigentlichen Prüfstiften vorzusehen. Es kommt hinzu, daß das Herstellen und Einbringen der Stützstifte in einen Adapter einen nicht unerheblichen zusätzlichen Fertigungsaufwand darstellt.

Es gibt Adapteranordnungen, bei denen federnde Prüfstifte (US-PS 3 654 585) bzw. biegeelastische Drahtstückchen (EP 184 619) mit vergleichbarer Funktion parallel zueinander in einem im wesentlichen starren bzw. zusammendrückbaren Massivkörper, d. h. einer sogenannten "Vertikalleiterplatte" angeordnet sind, doch wird dabei die eigentliche Übersetzung oder Adaptierung zwischen den ungleichmäßig angeordneten prüflingsorientierten Kontaktpunkten und den streng rasterförmig angeordneten Kontakten des Prüfgerätes durch eine zusätzliche "transition plate" bzw. "Umsetzerplatte" bewerkstelligt, die nach üblichen Leiterplattentechniken mit gegeneinander versetzten Kontaktflächen auf beiden Plattenoberflächen und "Durchsteigern" zum Verbinden der Kontaktflächen versehen sind. Diese Adapteranordnungen erfordern also einen erhöhten Fertigungsaufwand allein schon durch das Erfordernis der sogenannten "Umsetzer- oder Adapterplatte".

Einen erhöhten Fertigungsaufwand erfordert auch die Vorrichtung zur Prüfung von elektrischen Leiterplatten nach der WO 88/03651, die zwischen der Leiterplatte und einem Grundadapter als Zwischenadapter vorgesehen ist. Zur Umsetzung eines Rasterversatzes sowie eines Rasters mit kleinerer Rasterschrittweite auf das Raster von Kontaktflächen im Grundadapter sind mit einer Füllmasse wie Polyesterharz ausgegossene sogenannte Umsetzer vorgesehen, die auf ihrer Oberseite prüflingsspezifische Anordnungen von Kontaktnadeln, beispielsweise für SMD-Bauelemente, tragen. Auf der Unterseite verfügen die Umsetzer über Kontaktstifte in einem dem Kontaktflächenfeld des Grundadapters entsprechenden Raster. Das Rasterfeld der Kontaktstifte ist gegenüber den Seitenkanten der Umsetzer seitlich oder diagonal verschoben, so daß durch Drehen der Umsetzer um ihre Längsachse ein Versetzen der Kontaktstifte zum Kontaktieren der Kontaktflächen des Grundadapters durchgeführt werden kann.

Die oben dargestellten Nachteile im Stand der Technik werden durch einen Adapter gemäß Patentanspruch 1 vermieden. Die Notwendigkeit zum vorbereitenden Bohren mehrerer Adapterplatten mit unterschiedlichen Bohrmustern entfällt hierdurch vollkommen und zugleich wird jede(r) zu prüfende Leiterplatte/Verdrahtungsträger auf seiner gesamten Fläche überall gleichmäßig unterstützt, so daß eine lokale Massierung von Prüfstiften auf der einen Seite des Prüflings selbst ohne eine entsprechende Massierung von Prüstiften oder ohne zusätzliche Stützstifte auf der anderen Seite des Prüflings nicht zu Problemen im Hinblick auf eine zu große Krafteinleitung in den Prüfling führt.

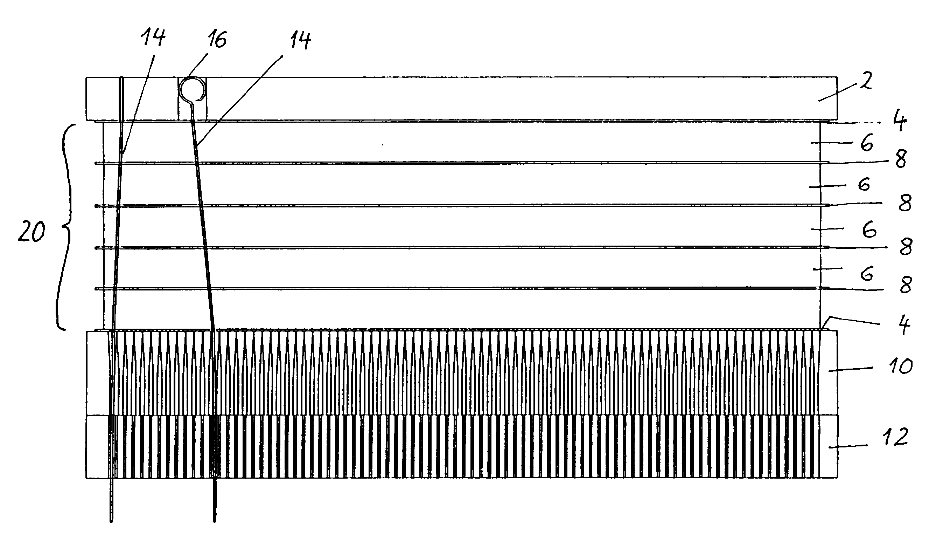

Die beiliegende Figur zeigt eine gegenwärtig bevorzugte Ausführungsform eines Adapters nach der vorliegenden Erfindung. Er weist in herkömmlicher Weise eine prüflingsspezifisch gebohrte obere Adapterplatte 2 und eine untere Rasterlochplatte 10 auf, wobei der Bereich dazwischen erfindungsgemäß durch ein geeignetes, möglichst inkompressibles Material hoher Flächendruckfestigkeit bei geringer Dichte vollständig ausgefüllt ist, nämlich im gezeigten Beispiel durch einen Verbundwerkstoff, der aus verschiedenen Schichten aufgebaut ist, nämlich aus einer an der Bodenfläche der oberen Platte 2 anliegenden Phenolpapierschicht 4, an die sich eine darunterliegende, verhältnismäßig dicke Schicht eines porösen Schaumstoffmaterials, wie Polystyrol, gegebenenfalls auch Balsaholz oder dergleichen, anschließt. Darunter ist dann eine relativ dünne Schicht eines Faservlieses 8 vorgesehen, das eine stabilisierende Wirkung in radialer Richtung auf den den Verbundwerkstoff durchsetzenden Prüfstift 14 hat. Im Anschluß daran folgt weiter abwärts wiederum ein poröses Schaumstoffmaterial 6 und erneut eine stabilisierende Faservliesschicht 8, wobei sich im dargestellten Beispiel diese Materialabfolge mehrfach wiederholen kann, wie sich dies aus der Zeichnung ergibt. Die letzte untere Schicht 8 eines porösen Schaumstoffmaterials wird nach unten von einer Phenolpapierschicht 4 abgeschlossen, die auf einer herkömmlichen Rasterlochplatte aufliegt, deren einzelne Bohrungen - wie aus der Zeichnung ersichtlich - oben einen etwas größeren Durchmesser haben als unten, um eine eventuell leichte Abweichung des Prüfstiftes vom gewollten Prüfstiftkanal durch den Vollmaterialkörper 20 auszugleichen. Unterhalb der Rasterlochplatte 10 ist noch eine kompressible Rasterlochmatte 12 vorgesehen, die für eine leichte federnde Nachgiebigkeit des Adapters in Vertikalrichtung sorgt, also z. B. 3 - 6 mm Federweg in einem typischen Anwendungsfall, um auf diese Weise für alle auftretenden Kontakthöhentoleranzen oder Variationen der Prüfstiftlänge einen ausreichenden Kontaktdruck zu erhalten. Unterhalb dieser kompressiblen Rasterlochmatte 12 befindet sich das an sich bekannte rastergebundene Kontaktpunktanschlußfeld der eigentlichen elektronischen Leiterplattenprüfvorrichtung, auf die allerdings vorliegend nicht näher eingegangen wird, da dies herkömmlicher Stand der Technik ist.

Soweit in dem erfindungsgemäßen Vollmaterialadapter völlig glatte konturlose Prüfstifte 14 verwendet werden, kann ein Herausfallen derselben aus dem Vollmaterialadapter dadurch verhindert werden, daß beim Einstechen der Prüfstiftkanäle darauf geachtet wird, daß in jedem Fall eine geringfügige Biegung des Prüfstiftes verursacht wird, wie dies bei den beiden dargestellten Prüfstiften der Zeichnung zu sehen ist. Eine solche leichte Biegung kann durch eine geeignete Steuerung des Einsetzens der Prüfstifte bzw. durch eine geeignete Berechnung der Prüfstiftkanäle im Zusammenwirken mit der Rasterlochplatte 10 und der Rasterlochmatte 12 erreicht werden.

In der Zeichnung sind aus Gründen der vereinfachten Darstellung lediglich zwei Prüfstifte (wenn auch mit unterschiedlichem Kopf) dargestellt, obwohl in der Praxis solcher Adapter regelmäßig einige Dutzend bis hinauf zu einigen Tausend Prüfstiften pro Adapter zum Einsatz kommen können, wobei je nach Anwendungsfall-wie dargestellt - auch konturlose Prüfstifte gemischt mit Prüfstiften mit einem geeigneten Kopf 16 Verwendung finden können, der einfach durch Umbiegen eines an sich konturlosen glatten Prüfstiftes entstehen kann. Der den Vollmaterialkörper 20 des Adapters durchsetzende und den Prüfstift 14 aufnehmende Prüfstiftkanal wird in bevorzugter, wenn auch nicht ausschließlicher Weise dadurch hergestellt, daß entweder der Prüfstift 14 selbst oder eine etwas (z.B. 50%) dickere Nadel von einer an sich bekannten Prüfstiftsetzmaschine in den Vollmaterialkörper 20 eingestochen wird. Derartige Prüfstiftsetzmaschinen sind bekannter Stand der Technik und finden seit längerem Anwendung zum Bestücken von herkömmlichen, eingangs diskutierten Plattenadaptern. Diese Prüfstiftsetzmaschinen sind in der Lage, einen Prüfstift oder-falls dieser zu dünn ist - eine etwas dickere Nadel an einer genau vorbestimmten Position und mit einer genau vorbestimmten Schräglage in den Vollmaterialkörper 20 einzustechen, d. h. der Prüfstiftkanal kann vorzugsweise zugleich mit dem Einsetzen des Prüfstiftes in den Adapter hergestellt werden. Zu diesem Zweck muß das zur Anwendung kommende Material des Vollmaterialkörpers einerseits weich genug sein, damit ein solcher Prüfstift problemlos eingestochen werden kann, andererseits muß das Material eine verhältnismäßig hohe Flächendruckfestigkeit haben, um die prüflingsspezifisch gebohrte obere Adapterplatte 2 auf ihrer gesamten Fläche kontinuierlich abzustützen. Ein für diese Zwecke bevorzugtes Material ist z. B. Styropor oder Balsaholz oder ähnliche Materialien, also ein im wesentlichen inkompressibles Material geringer Dichte aber mit relativ hoher Flächendruckfestigkeit. Ähnlich brauchbar sind Materialien aus harten Kunststoffschäumen oder solche auf der Basis von Glasfasern.

Es ist durchaus denkbar, die im Vollmaterialkörper 20 erforderlichen durchgehenden Prüfstiftkanäle durch geeignete andere Techniken als durch Einstechen mit Hilfe einer Nadel zu erzeugen. Beispielsweise können solche Bohrungen auch durch Laserstrahlen, Ultraschallbohren, mechanisches Bohren, Brennen, Wasserstrahlen oder ähnliche Techniken erzeugt werden, auch wenn das Einstechen in dafür geeignete Materialien mit Hilfe einer Prüfstiftsetzmaschine zur Zeit bevorzugt wird.

Der Aufsetzpunkt der in den Vollmaterialkörper 20 einzustechenden Nadel kann durch eine darauf aufliegende Lochplatte definiert werden, die entweder eine prüflingsspezifisch gebohrte Platte oder eine Rasterlochplatte sein wird, je nachdem, von welcher Seite des Vollmaterialkörpers 20 aus in diesen eingestochen wird. Im dargestellten Ausführungsbeispiel ist davon auszugehen, daß das Einstechen der Nadel bzw. des Prüfstiftes 14 von der Prüflingsseite erfolgt ist, wobei die konischen Bohrungen in der Rasterlochplatte 10 dazu dienen, leichte Abweichungen vom gewollten Prüfstiftkanal am unteren Ende auszugleichen und den Prüfstift genau auf den jeweiligen rastergebundenen Kontaktpunkt der Prüfmaschine hinzuführen, der im Fall der kompressiblen Rastermatte 12 am unteren Ende der Bohrung darin angeordnet sein wird.

Die verwendeten Prüfstifte können konturlose, sogenannte "music-wire" Prüfstifte sein, die einen Durchmesser von bis herunter zu 0,1 mm oder 0,004 Zoll haben. Nachdem ein derart dünner kopfloser Prüfstift in manchen Anwendungsfällen eines Adapters zu dünn für den zu prüfenden, oft als Bohrung ausgeführten Anschlußpunkt auf der Leiterplatte sein kann, d. h. daß die Gefahr besteht, daß kein brauchbarer Kontakt zwischen dem konturlosen Prüfstift und dem Kontaktpunkt auf dem Prüfling zustandekommt, kann vorzugsweise ein ausreichend großer Kopf 16 an diesem konturlosen Prüfstift dadurch ausgebildet werden, daß er am oberen, am Prüfling anliegenden Ende in geeigneter Weise, also z. B. kreisförmig, umgebogen oder abgebogen wird, also etwa nach Art eines Bischofsstabes oder dergleichen. Hierdurch gelingt es in besonders vorteilhafter Weise, auch bei besonders dünnen konturlosen Prüfstiften, die bei hohen Kontaktdichten eingesetzt werden, relativ große Kontaktpunkte (etwa in Form von Bohrungen/Durchsteigern) in einem Prüfling zu kontaktieren, ohne daß es eines großen Fertigungsaufwandes für einen Prüfstiftkopf bedarf. Je nach Prüfling können die Prüfstifte mit und ohne derartige Köpfe in einem Adapter gemischt vorkommen.

## Patentansprüche

1. Adapter zur Anpassung des gleichmäßigen Kontaktrasters einer elektrischen Prüfvorrichtung für Leiterplatten an die ungleichmäßige Kontaktkonfiguration der Anschlußpunkte auf einer ein- oder beidseitig zu prüfenden Leiterplatte mit nadelartigen Prüfstiften, die mit ihrem einen Ende auf den regelmäßig verteilten Kontakten des Kontaktfeldes der Prüfvorrichtung aufliegen, sich durch die Prüfstiftkanäle des Adapters erstrecken und mit ihren anderen Enden die meistens unregelmäßig verteilten Anschlußpunkte der zu prüfenden Leiterplatte kontaktieren, wobei die Deckfläche des Adapters an der zu kontaktierenden Fläche der Leiterplatte und die Bodenfläche des Adapters auf dem Kontaktfeld der Prüfvorrichtung anliegt, dadurch gekennzeichnet, daß der Adapter im Bereich zwischen seiner Bodenfläche und seiner Deckfläche ein im wesentlichen inkompressibler Vollmaterialkörper geringer Dichte und hoher Flächendruckfestigkeit ist, der durchgängig von den Prüfstiftkanälen durchsetzt ist, die durch Einstechen von Nadel in den Vollmaterialkörper hergestellt sind.

2. Adapter nach Anspruch 1, dadurch gekennzeichnet, daß der Adapterkörper aus einem in sich einheitlichen Material, wie Balsaholz, Styropor oder einem sonstigem Kunststoff-Hartschaummaterial ausgebildet ist.

3. Adapter nach Anspruch 1 oder 2, dadurch gekennzeichnet, daß der Adapterkörper aus einem mehrschichtigen Verbundwerkstoff aufgebaut ist.

4. Adapter nach Anspruch 3, dadurch gekennzeichnet, daß der Verbundwerkstoff aus mehreren Lagen aus einem im wesentlichen inkompressiblen Vollmaterial geringerer Dichte und hoher Flächendruckfestigkeit mit dazwischen angeordneten Lagen eines Faservlieses aufgebaut ist.

5. Adapter nach einem der vorhergehenden Ansprüche, dadurch gekennzeichnet, daß die Deckfläche des Verbundkörpers von einer prüflingsspezifisch gebohrten, vorzugsweise abnehmbaren Platte, z. B. einer Plexiglasplatte, gebildet ist.

6. Adapter nach einem der vorhergehenden Ansprüche, dadurch gekennzeichnet, daß die Bodenfläche des Verbundkörpers von einer rasterspezifisch gebohrten, vorzugsweise abnehmbaren Rasterführungsplatte (10, 12) gebildet wird, deren Raster dem Raster der zu prüfenden Leiterplatte oder einem anderem, vorzugsweise dichterem Raster entspricht.

7. Adapter nach Anspruch 6, dadurch gekennzeichnet, daß die dem Verbundkörper (20) zugewandten Enden der Bohrungen in der Rasterführungsplatte (10) konisch aufgeweitet sind derart, daß der Durchmesser mit zunehmendem Abstand von der äußeren Bodenfläche größer wird.

8. Adapter nach einem der vorhergehenden Ansprüche, dadurch gekennzeichnet, daß die Prüfstifte als konturlose Starrstifte (14) ausgebildet sind und auf ein aktives Grundraster / einen Federfeldkörper wirken.

9. Adapter nach einem der vorhergehenden Ansprüche, dadurch gekennzeichnet, daß die Prüfstifte wenigstens teilweise als konturlose, glatte Starrstifte ausgebildet sind und einen Kopf in Gestalt eines hakenförmig oder kreisförmig umgebogenen Stiftendes haben.

10. Adapter nach einem der vorhergehenden Ansprüche, dadurch gekennzeichnet, daß die Prüfkanäle durch Einstechen von Nadeln in den Vollmaterialkörper hergestellt sind, deren Durchmesser bis zu ca. 50 % größer sind als der Durchmesser der in diese Prüfstiftkanäle einzusetzenden Prüfstifte.

11. Adapter nach einem der vorhergehenden Ansprüche, dadurch gekennzeichnet, daß die Nadeln und/oder die Prüfstifte durch einen an sich bekannten Prüfstiftsetzer in den Vollmaterialkörper eingebracht werden.

12. Prüfstift zur Verwendung in einem Prüfstiftadapter für Leiterplatten, in einem Adapter nach einem der voranstehenden Ansprüche, dadurch gekennzeichnet, daß an einem an sich bekannten glatten konturlosen Prüfstift ein Prüfstiftkopf in Gestalt eines kreis- oder hakenförmig umgebogenen bzw. abgebogenen Prüfstiftabschnittes ausgebildet ist.

## Claims

1. Adapter for adapting the uniform contact-grid of an electrical testing-device for PCB's to the irregular contact-configuration of contact-points of a PCB to be tested on one or both sides, with needle-like test-pins which lie, with one of their ends, on the regularly distributed contacts of the contact-field of the testing-device, and which extend through the test-pin channels of the adapter and which contact, with their other ends, the mostly irregularly distributed contact-points of the PCB to be tested, whereby the cover surface of the adapter lies on the surface of a PCB to be contacted and the base-surface of the adapter lies on the contact-field of the testing-device, characterized in that the adapter, in the zone between its base-surface and its cover surface, is an essentially incompressible solid body of low density and high surface-pressure resistance, which is passed through by the test-pin channels which are produced by plunging-in of needles into the solid body.

2. Adapter in accordance with claim 1, characterized in that the adapter body is formed from a uniform material such as balsa wood, Styrofoam or another synthetic, hard-foam material.

3. Adapter in accordance with claim 1 or claim 2, characterized in that the adapter body is assembled from a multi-layered composite material.

4. Adapter in accordance with claim 3, characterized in that the composite material is built up by several layers of an essentially incompressible solid material of low density and high surface-pressure resistance, and interposed layers of a fibre-fleece.

5. Adapter in accordance with any preceding claim, characterized in that the cover surface of the composite body is formed from a testpiece-specific, bored, preferably removable, plate, a plexiglass plate for example.

6. Adapter in accordance with any preceding claim, characterized in that the base-surface of the composite body is formed by a grid-specific, bored, preferably removable grid guide-plate (10, 12), the grid of which corresponds to the grid of the PCB to be tested or to another, preferably denser, grid.

7. Adapter in accordance with claim 6, characterized in that the ends of the borings, in the grid guide-plate (10), facing the composite body (20), are conically opened such that the diameter increases with increasing separation from the outer base-surface.

8. Adapter in accordance with any preceding claim, characterized in that the test-pins are developed as contourless, rigid pins (14) and act on an active base-grid/spring-field body.

9. Adapter in accordance with any preceding claim, characterized in that the test-pins are at least partly developed as contourless, flat rigid pins and have a head in the form of a pin-end which is arched round in a hook-form or circular form.

10. Adapter in accordance with any preceding claim, characterized in that the test channels are produced by plunging-in of needles into the solid body, these needles having a diameter which is up to 50% greater than the diameter of the test-pins to be inserted into these test-pin channels.

11. Adapter in accordance with any preceding claim, characterized in that the needles and/or the test-pins are introduced into the solid body by means of a known test-pin setter.

12. Test-pin for use in a test-pin adapter for PCB's, in an adapter in accordance with any one of the preceding claims, characterized in that a test-pin head is formed in the form of a test-pin section arched round or arched backwards in a circular or hook form on a known, flat, contourless test-pin.

## Revendications

1. Adaptateur pour l'adaptation de la grille de contacts régulière d'un appareil électrique de contrôle de cartes imprimées à la configuration de contacts irrégulière des points de connexion d'une carte imprimée à contrôler sur une face ou sur ses deux faces, au moyen l'aiguilles de test qui s'appuient à une de leurs extrémités sur les contacts régulièrement répartis de la plage de contacts de l'appareil de contrôle, passent dans des canaux de l'adaptateur et viennent en contact à leurs autres extrémités avec Les points de connexion généralement irrégulièrement répartis de la carte imprimée à contrôler, la face supérieure de l'adaptateur s'appuyant sur la face à contacter de la carte imprimée et la face inférieure de l'adaptateur s'appuyant sur la plage de contacts de l'appareil de contrôle, caractérisé par le fait que l'adaptateur est, dans la zone entre sa face inférieure et sa face supérieure, un corps en matériau plein pratiquement incompressible de faible densité et à haute résistance à la pression superficielle qui est traversé par les canaux à aiguilles de test, qui sont réalisés par enfoncement d'aiguilles dans le corps en matériau plein.

2. Adaptateur selon la revendication 1, caractérisé par le fait que le corps d'adaptateur est constitué d'une matière unique telle que balsa, styropor ou autre plastique alvéolaire rigide.

3. Adaptateur selon l'une (les revendications 1 et 2, caractérisé par le fait que le corps d'adaptateur est constitué d'un matériau composite multicouche.

4. Adaptateur selon la revendication 3, caractérisé par le fait que le matériau composite est constitué de plusieurs couches d'un matériau plein pratiquement incompressible de faible densité et à haute résistance à la pression superficielle entre lesquelles sont placées des couches d'un voile de fibres.

5. Adaptateur selon l'une des revendications précédentes, caractérisé par le fait que la face supérieure du corps composite est formée d'une plaque par exemple en plexiglas percée selon l'objet à contrôler et de préférence amovible.

6. Adaptateur selon l'une des revendications précédentes, caractérisé par le fait que la face inférieure du corps composite est formée d'une plaque de guidage à grille (10, 12) percée sur une grille, de préférence amovible et dont la grille correspond à la grille de la carte imprimée à contrôler ou à une autre grille de préférence plus dense.

7. Adaptateur selon la revendication 6, caractérisé par le fait que les extrémités dirigées vers le corps composite (20) des trous de la plaque de guidage à grille (10) s'élargissent coniquement de façon telle que leur diamètre augmente avec la distance de la face inférieure extérieure.

8. Adaptateur selon l'une des revendications précédentes, caractérisé par le fait que les aiguilles de test sont des aiguilles rigides sans contours (14) et agissent sur une grille de base active/un corps à plage à ressorts.

9. Adaptateur selon l'une des revendications précédentes, caractérisé par le fait que les aiguilles de test, au moins en partie, sont des aiguilles rigides unies sans contours et ont une tête formée d'une extrémité recourbée en forme de crochet ou de cercle.

10. Adaptateur selon l'une des revendications précédentes, caractérisé par le fait que les canaux de test sont réalisés par enfoncement dans le corps en matériau plein d'aiguilles dont le diamètre est supérieur de jusqu'à 50 % au diamètre des aiguilles de test à introduire dans ces canaux.

11. Adaptateur selon l'une des revendications précédentes, caractérisé par le fait que les aiguilles et/ou les aiguilles de test sont introduites dans le corps en matériau plein au moyen d'une machine de pose d'aiguilles de test connue.

12. Tige de test destinée à être utilisée dans un adaptateur d'aiguilles de test pour cartes imprimées, dans un adaptateur selon l'une des revendications précédentes, caractérisée par le fait que sur une aiguille de test unie sans contours connue est faite une tête formée d'un tronçon d'aiguille recourbé ou replié en forme de cercle ou de crochet.
